# EUROPEAN PATENT APPLICATION

(11) **EP 4 664 524 A1**
(43) Date of publication of application: **17.12.2025**
(21) Application number: 25182825.7
(22) Date of filing: 13.06.2025
(51) Int. Cl.: H01L 23/495, H01L 23/34, H01L 23/48, H01L 23/31

(54) **DISCRETE SEMICONDUCTOR DEVICE PACKAGE WITH INTEGRATED TEMPERATURE SENSOR**

(30) Priority: 14.06.2024 CN 202410768625
(71) Applicant: Littelfuse Semiconductor (Wuxi) Co., Ltd., Wuxi, Jiangsu 214142 (CN)
(72) Inventor: Perraud, Francois, Wuxi, 214142 (CN); Bhatt, Aalok, Wuxi, 214142 (CN); Hughes, Rhodri, Wuxi, 214142 (CN); Bono, Richard J., Wuxi, 214142 (CN); Zhang, Lucas, Wuxi, 214142 (CN)
(74) Representative: Arnold & Siedsma

(57) **Abstract**

A semiconductor package is provided. The semiconductor package may include a housing; a semiconductor chip, disposed within the housing; a top connector, connected to the semiconductor chip; a leadframe, coupled to the top connector; and a temperature sensor chip, disposed on the top connector.

## Description

### Background

### Field

The disclosure relates to the field of semiconductor devices, and in particular, discrete power semiconductor devices.

### Discussion of Related Art

Modern power semiconductor devices are formed in semiconductor die (chips) with different technologies such as silicon-controlled rectifiers ("SCRs"), power transistors, insulated gate-bipolar transistors ("IGBTs"), metal-oxide-semiconductor field effect transistors ("MOSFETs"), bipolar power rectifiers, diodes, thyristors, Triacs, and most recently, devices fabricated using the wide band gap semiconductor materials such as Silicon Carbide (SiC), Gallium Nitride (GaN) or combinations thereof. The semiconductor chips may be assembled in power modules or discrete chip carrier packages. Due to the flexibility for the design of electric power conversion boards, and the simplicity of use in automated manufacturing lines, surface mount discrete chip carriers for power semiconductor chips are gaining popularity for different applications. As an example, such discrete chip carriers are used in increasingly high-power conversion systems, in competition with power modules that may include multiple power chips and associated hardware. However, due to limited space and packaging concerns, such discrete chip carriers may not provide the same functionality as power modules. As an example, power modules may accommodate temperature sensors and other components in addition to power semiconductor devices, while known discrete carries do not include such components.

In view of the above, the present disclosure is provided.

### Brief Summary

A semiconductor package is provided. The semiconductor package may include a housing; a semiconductor chip, disposed within the housing; a top connector, connected to the semiconductor chip; a leadframe, coupled to the top connector; and a temperature sensor chip, disposed on the top connector.

A discrete power semiconductor package is provided. The discrete power semiconductor package may include a housing; a power semiconductor chip, disposed within the housing; a top connector, connected to a first main terminal of the semiconductor chip; and a temperature sensor chip, disposed on the top connector, wherein the temperature sensor chip is coupled in thermal contact with the power semiconductor chip, and wherein the semiconductor package comprises a discrete chip carrier.

### Brief Description of the Drawings

**FIG. 1** shows a circuit representation of discrete semiconductor device , in accordance the disclosure;
**FIG. 2A** depicts a top view of a discrete semiconductor device package, according to he disclosure;
**FIG. 2B** depicts perspective view of the package of FIG. 2A;
**FIG. 2C** depicts a transparent view of the package of FIG. 2A.
**FIG. 3A** depicts a top view of another discrete semiconductor device package, according to the disclosure;
**FIG. 3B** depicts perspective view of the package of FIG. 3A;
**FIG. 3C** depicts a transparent view of the package of FIG. 3A.
**FIG. 4A** depicts a perspective view of a further discrete semiconductor device package, according to the disclosure;
**FIG. 4B** depicts a transparent top view of the package of FIG. 4A; and
**FIG. 5** depicts a transparent top view of an additional discrete semiconductor device package, according to the disclosure.

### Description of Embodiments

The present disclosure will now be described more fully hereinafter with reference to the accompanying drawings. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

The present disclosure as described herein below, is designed to improve the performance of discrete semiconductor device packages. Such packages may be referred to as discrete chip carriers, meaning a package whose footprint is designed to house just one power semiconductor die, for example. The present embodiments provide a novel discrete device carrier that includes a built-in temperature sensor component, to monitor the temperature of a power chip. This architecture provides a way to read the temperature variations of a semiconductor chip inside a discrete package with minimum delay, providing the ability to foresee and as much as possible, prevent a catastrophic failure of the semiconductor device that may be caused by overcurrent, or aging, for example. As used herein, a "discrete package" or "discrete chip carrier" may refer to a semiconductor device package having just one power semiconductor chip contained therein, and may be characterized by a relatively smaller planar area, such as less than 2000 mm², or less than 1800 mm². In some embodiments, just one power semiconductor die may be arranged in the discrete package, or just one power semiconductor die plus an accompanying diode die, for example.

Non-limiting examples of power semiconductors suitable for the present embodiments include silicon-based devices, and SiC, GaN, power semiconductor devices. A discrete chip carrier may include a semiconductor power device such as power transistors, insulated gate-bipolar transistors ("IGBTs"), metal-oxide-semiconductor field effect transistors ("MOSFETs"), bipolar power rectifiers, diodes, silicon-controlled rectifiers ("SCRs"), Triacs, and so forth.

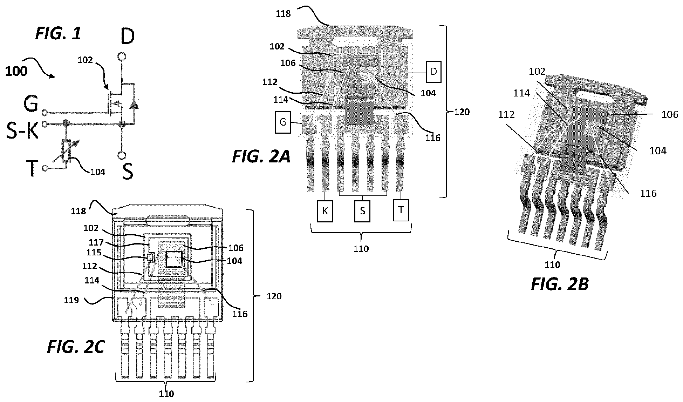

**FIG. 1** shows a circuit representation of discrete semiconductor device package, in accordance with the disclosure. The circuit 100 may be implemented in any of the semiconductor device packages to be disclosed with respect to FIGs. 2A-5.

Turning again to FIG. 1, the circuit 100 represents a discrete power semiconductor device package arrangement for operating a power semiconductor chip, in this case being implemented as a power MOSFET. The MOSFET gate terminal is shown as G, the source terminal as S, the drain terminal as D. The circuit 100 further includes a Kelvin source terminal as S-K and a T terminal that is coupled in parallel with S/K terminals to the source of the MOSFET transistor. This circuit arrangement may be used to monitor the temperature of a semiconductor chip in a discrete package, using a temperature sensor 104 that is incorporated directly in the circuit 100 and coupled to the terminal T.

**FIG. 2A** depicts a top view of a discrete semiconductor device package, according to some embodiments of the disclosure. FIG. 2B depicts perspective view of the package of FIG. 2A. FIG. 2C depicts a transparent view of the package of FIG. 2A.

In particular, a discrete semiconductor device package, referred to herein as semiconductor package 120, is shown. In this example, the semiconductor package 120 may include a die attach tab 118, a semiconductor chip 102, disposed on the die attach tab 118, a top connector 106, connected to the semiconductor chip 102, a leadframe 110, coupled to the top connector 106, and a temperature sensor chip 104, disposed in contact with the semiconductor chip 102. As such, the semiconductor package 120 is arranged as a discrete chip carrier.

The top connector 106 may be shaped as a bent clip, made of a suitable material that is both electrically conductive and thermally conductive, such as copper, copper alloy, or other suitable metal.

The temperature sensor chip 104 may be formed with a negative temperature coefficient (NTC) device. As such, when the temperature of the semiconductor chip 102 increases, the resistance of the temperature sensor chip 104 may decrease, leading to a measurable change within circuit 100. The temperature sensor chip 104 may be a leadless top-bottom terminated chip, as known in the art. As such a top surface and bottom surface of temperature sensor chip 104 may be metallized. In this manner, the electrical resistance of the temperature sensor chip will vary with temperature in a predetermined relationship based upon the material and dimensions of the temperature sensor chip. This temperature dependence of resistance allows the temperature of the temperature sensor chip 104 to be determined by measuring resistance-dependent properties, such as voltage, across the temperature sensor chip 104.

In the semiconductor package 120, a first main terminal that is used as a power terminal (such as source S, in the case of a power MOSFET) of the semiconductor chip 102 and a gate terminal (not separately shown in FIG. 2A) may be disposed on a first main surface of the semiconductor chip 102, meaning the surface visible in FIG. 2A. Moreover, the top connector 106 may be a metal clip that is connected in electrical series between a set of power leads of the leadframe 110, and the first main terminal. The die attach tab 118 acts as a second main terminal (power terminal), representing the drain terminal D in the MOSFET example of FIG. 1

In FIG. 2A, the lead frame includes a Kelvin lead (K), representing the S-K terminal of FIG. 1, source leads (S) that act as power leads to couple power through the semiconductor chip 102, representing the S terminal of FIG. 1, as well as a temperature lead (T) representing the terminal T. Using wire 114, the Kelvin lead (K) can be wire bonded to the top connector 106, while the gate lead (G) is wire bonded using wire 112 directly to the upper surface of the semiconductor chip. In particular, as shown more clearly in FIG. 2C, the wire 112 is bonded to a gate terminal 115 that is defined on the upper surface. In addition, the temperature lead (T) is wire bonded using wire 116 to the temperature sensor chip 104.

With reference also to FIG. 2C, by placing a temperature sensor chip 104 on the top connector 106, the temperature sensor chip 104 is in close thermal contact with the semiconductor chip 102, while not affecting the design of the semiconductor chip 102. For example, the top connector 106 may have a flat portion that is affixed directly to a source terminal 117 of the semiconductor chip, while the upper surface of the semiconductor chip also includes the gate terminal 115 to connect to the gate lead (G) (see FIG. 2A). The top connector 106 may be formed substantially of a highly electrically conductive material such as copper and may contact the source terminal 117 over a relative large fraction of the source electrode, thus enabling a relatively large current to be conducted from the source leads (S) through the semiconductor chip 102. Moreover, because the top connector 106 may be formed of a relatively high electrical conductor, the top connector 106 may also be a relatively good thermal conductor, such as copper, ensuring that the measurement of temperature of the semiconductor chip using temperature sensor chip 104 is accurate, and that temperature changes of the semiconductor chip 102 changes are rapidly sensed. Moreover the top connector 106 may be placed in contact with a large fraction of the surface of the semiconductor chip, such as 40%, 50 %, or 60% of the surface. Because the top connector 106 may be a highly thermally conductive material, the heat generated by the semiconductor chip 102 is more uniformly distributed in a lateral direction with the plane defined by the semiconductor chip 102, ensuring more accurate temperature measurement.

At the same time, because the temperature sensor chip 104 is placed on top of the top connector 106, the design of top connector 106 can be optimized for contact with the semiconductor chip 102. In other words, the placement, size or shape of the top connector on the semiconductor chip 102 is not affected by the presence of a temperature sensor chip, as would be the case if the temperature sensor chip 104 were placed directly on the semiconductor chip 102.

As further shown in FIG. 2C, the semiconductor package 120 may include a housing 119, such as an insulating body, for containing the semiconductor chip 102, temperature sensor chip 104, and top connector 106, among other features. Note that the die attach tab 118 may be conductive body such as copper, and may be used to make electrical contact with the drain terminal of the semiconductor chip 102. Additionally, the die attach tab 118 may be exposed on a lower side of the housing 119, for external electrical connection.

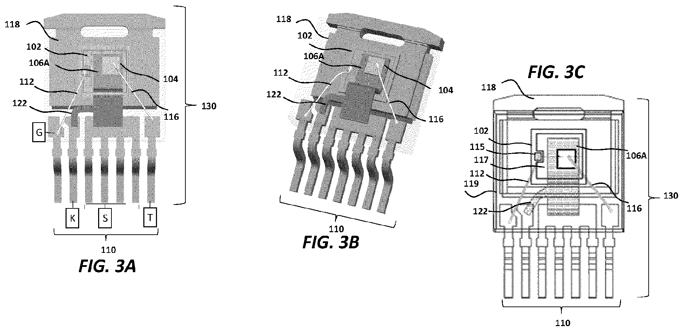

FIG. 3A depicts a top view of another discrete semiconductor device package, according to the disclosure. FIG. 3B depicts perspective view of the package of FIG. 3A; FIG. 3C depicts a transparent view of the package of FIG. 3A. In the example of FIG. 3A, the semiconductor package 130 may be arranged similarly to semiconductor package 120, with like components labeled the same. A difference is that, instead of providing a wire bond to connect the Kelvin lead (K) to a top connector 106, the semiconductor package 130 may be arranged with a top connector 106A that includes a side arm 122 that is connected to the Kelvin lead (K). In particular, the side arm 122 may be integrally formed within the top connector 106A, such that the whole of top connector 106A may be formed from a single metal sheet or plate. This configuration may be suitable when size constraints make it difficult or unfeasible to make a wirebond connection direction from the K lead.

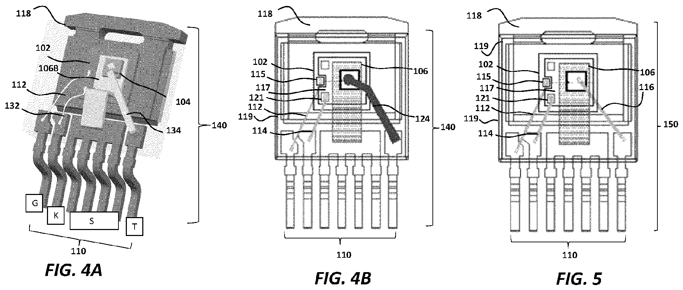

**FIG. 4A** depicts a perspective view of a further discrete semiconductor device package, according to the disclosure. **FIG. 4B** depicts a transparent top view of the package of FIG. 4A. A difference in the semiconductor package of FIG. 4A with respect to the package of FIG. 2A is that, instead of providing a wire bond 116 to connect the temperature sensor lead (T) to the top connector 106, the semiconductor package 130 may be arranged with metal clip 134 that is connected to the temperature sensor lead (T) and temperature sensor chip 104. In particular, the metal clip 134 may formed from a metal sheet or plate. In addition, the wire from a Kelvin lead (K) is bonded directly to a tab 121 in the region of the source terminal 117, on the upper surface of the semiconductor chip 102.

**FIG. 5** depicts a transparent top view of an additional discrete semiconductor device package, according to the disclosure. A difference in the semiconductor package 150 of FIG. 5 with respect to the package of FIG. 4A is that, a wire bond may be provided 116 to connect the temperature sensor lead (T) to the top connector 106, the semiconductor package instead of the metal clip 134.

While the disclosure detailed above may illustrate a discrete package for a MOSFET power device, in other cases, an IGBT, Silicon controlled rectifier (SCR), thyristor, diode, wide band gap device including SiC or GaN, or other power semiconductor device may be used in the configurations generally illustrated in FIGs. 1- 5. Such packages will generally include the temperature sensor chip 104, top connector 106, a set of source leads (S), a gate lead (G), a Kelvin lead (K), a temperature sensor lead 104, and various other components as illustrated in the different configurations of FIGs. 1-5.

Moreover, while the disclosed above illustrate semiconductor packages that include a leadframe, in further cases of the disclosure a discrete package that includes a semiconductor chip 102, top connector 106, and temperatures sensor chip 104 may be coupled directly to a substrate, such as a DCB (direct copper bonded), AMB (active metal braze), PCB (printed circuit board), IMS (insulated metal substrate). Note that, while the leadframe configurations depicted in the above figures may be suitable for non-isolated packages, in embodiments of isolated packages, such as DCB or AMB, an additional drain terminal and lead may be added to the aforementioned packages, while the other components in said packages will remain the same.

## Claims

1. A semiconductor package, comprising:
a housing;
a semiconductor chip, disposed within the housing;
a top connector, connected to the semiconductor chip;
a leadframe, coupled to the top connector; and
a temperature sensor chip, disposed on the top connector,
wherein the semiconductor package comprises a discrete chip carrier.

2. The semiconductor package of claim 1, wherein the temperature sensor chip comprises a negative temperature coefficient (NTC) device.

3. The semiconductor package of claim 1 or 2, wherein the semiconductor chip comprises a power semiconductor having a first main terminal and a gate terminal that are disposed on a first main surface of the semiconductor chip, wherein the top connector is a metal clip that is connected in electrical series between a set of power leads of the leadframe, and the first main terminal.

4. The semiconductor package of any of the claims 1-3, the lead frame further comprising a temperature lead, electrically coupled to the temperature sensor chip.

5. The semiconductor package of any of the preceding claims, wherein the leadframe further comprises a Kelvin lead, coupled to the first main surface of the semiconductor chip, preferably
wherein the Kelvin lead is wire bonded to the top connector.

6. The semiconductor package of claim 5, wherein the top connector comprises a side arm that is connected to the Kelvin lead.

7. The semiconductor package of any the claims 4-6, wherein the temperature lead is coupled to the temperature sensor chip using a metal clip.

8. The semiconductor package of any of the preceding claims ,further comprising:
a die attach tab, disposed at least partially within the housing, wherein the semiconductor chip is disposed on the die attach tab, and/or wherein the semiconductor chip comprises a MOSFET, IGBT, thyristor, SCR, or diode.

9. A discrete power semiconductor package, comprising:
a housing;
a power semiconductor chip, disposed within the housing;
a top connector, connected to a first main terminal of the semiconductor chip; and
a temperature sensor chip, disposed on the top connector, wherein the temperature sensor chip is coupled in thermal contact with the power semiconductor chip, and
wherein the semiconductor package comprises a discrete chip carrier.

10. The discrete power semiconductor package of claim 10, wherein the temperature sensor chip comprises a negative temperature coefficient (NTC) device.

11. The discrete power semiconductor package of claim 9 or 10, wherein the semiconductor chip comprises a power semiconductor having a first main terminal and a gate terminal that are disposed on a first main surface of the semiconductor chip, wherein the top connector is a metal clip that is connected in electrical series between a set of power leads of a leadframe, and the first main terminal, preferably wherein the leadframe further comprises a temperature lead electrically coupled to the temperature sensor chip.

12. The discrete power semiconductor package of claim 11, wherein the leadframe further comprises one of the following:
- a Kelvin lead that is wire bonded to the top connector;
- a Kelvin lead that is wire bonded to a first main terminal of the power semiconductor chip;
- a Kelvin lead, wherein the top connector comprises a side arm that is connected to the Kelvin lead.

13. The discrete power semiconductor package of claim 11 or 12, wherein the temperature lead is coupled to the temperature sensor chip using a metal clip.

14. The discrete power semiconductor package of any of the claims 9-13, further comprising:
a die attach tab, disposed at least partially within the housing, wherein the semiconductor chip is disposed on the die attach tab.

15. The discrete power semiconductor package of any of the claims 9-14, further comprising:
a substrate, electrically connected to the semiconductor chip via the top connector.
